# EUROPÄISCHE PATENTSCHRIFT

(11) **EP 3 956 637 B1**
(45) Veröffentlichungstag und Bekanntmachung des Hinweises auf die Patenterteilung: **29.11.2023**
(21) Anmeldenummer: 20718565.3
(22) Anmeldetag: 26.03.2020
(51) Int. Cl.: G01D 3/036, G01D 5/14, G01B 7/30

(54) **SENSORVORRICHTUNG FÜR EIN FAHRZEUG, VERFAHREN ZUM HERSTELLEN UND ZUM BETREIBEN EINER SOLCHEN SENSORVORRICHTUNG UND SENSORSYSTEM FÜR EIN FAHRZEUG**
SENSOR DEVICE FOR A VEHICLE, METHODS FOR MANUFACTURING AND FOR OPERATING SUCH A SENSOR DEVICE AND SENSOR SYSTEM FOR A VEHICLE
DISPOSITIF CAPTEUR POUR UN VÉHICULE, PROCÉDÉS DE FABRICATION ET DE FONCTIONNEMENT D'UN TEL DISPOSITIF CAPTEUR ET SYSTÈME CAPTEUR POUR UN VÉHICULE

(30) Priorität: 16.04.2019 DE 102019109970
(43) Veröffentlichungstag der Anmeldung: 23.02.2022
(73) Patentinhaber: KNORR-BREMSE Systeme für Nutzfahrzeuge GmbH, 80809 München (DE)
(72) Erfinder: PRAMS, Stefan, 80637 München (DE)
(86) Internationale Anmeldenummer: PCT/EP2020/058516
(87) Internationale Veröffentlichungsnummer: WO 2020/212109

(56) Entgegenhaltungen:
- DE-A1-102010 040 584
- DE-A1-102014 010 601
- DE-A1-102015 116 303
- US-A1- 2013 125 669
- US-A1- 2016 258 781

## Beschreibung

Die vorliegende Erfindung bezieht sich auf eine Sensorvorrichtung für ein Fahrzeug, auf ein Verfahren zum Herstellen einer Sensorvorrichtung für ein Fahrzeug, auf ein Verfahren zum Betreiben einer Sensorvorrichtung für ein Fahrzeug und auf ein Sensorsystem für ein Fahrzeug, insbesondere das Gebiet der Magnetfeldsensorik. Bezüglich einer Absicherung gegenüber externen Magnetfeldern existieren insbesondere Methoden, wie beispielsweise metallische Schirmungen, zusätzliche Sensoren, die zur Erkennung solcher externen Magnetfelder dienen, oder Versuche externe Magnetfelder aus einem Nutzsignal herauszurechnen.

Das Dokument DE 10 2014 010 601 A1 beschreibt eine Sensorvorrichtung zur Bestimmung einer Position eines Gebermagneten, umfassend zwei Magnetfeldsensoren sowie Mittel zur Abschirmung eines der Magnetfeldsensoren gegenüber dem Magnetfeld des Gebermagneten.

Vor diesem Hintergrund ist es die Aufgabe der vorliegenden Erfindung, eine verbesserte Sensorvorrichtung für ein Fahrzeug, ein verbessertes Verfahren zum Herstellen einer Sensorvorrichtung für ein Fahrzeug, ein verbessertes Verfahren zum Betreiben einer Sensorvorrichtung für ein Fahrzeug und ein verbessertes Sensorsystem für ein Fahrzeug zu schaffen.

Diese Aufgabe wird durch eine Sensorvorrichtung für ein Fahrzeug, durch ein Verfahren zum Herstellen einer Sensorvorrichtung für ein Fahrzeug, durch ein Verfahren zum Betreiben einer Sensorvorrichtung für ein Fahrzeug, durch ein Sensorsystem für ein Fahrzeug und durch ein entsprechendes Computerprogramm gemäß den unabhängigen Ansprüchen gelöst. Die abhängigen Ansprüche definieren mögliche Ausführungsformen.

Gemäß Ausführungsformen kann insbesondere eine Auslegung einer Sensorvorrichtung oder eines Sensorverbunds derart realisiert werden, dass sich ein Einfluss eines externen Magnetfeldes auf die Vorrichtung verschiedenartig auf Sensoren, Sensorelemente, Sensorchips bzw. Sensorkanäle der Vorrichtung auswirkt, wobei die Auswirkung des externen Magnetfeldes sich zusätzlich von der Wirkung eines Gebermagnetfelds unterscheidet, genauer gesagt systematisch bzw. erkennbar unterscheidet. Dies kann auch bei einem Verfahren für Abgleich und Erkennung unter Verwendung einer solchen Vorrichtung ausgenutzt werden. Dies kann erreicht werden, obwohl externe Magnetfelder als sogenannter Common-Cause-Einfluss wirken, und somit kann eine absichernde Wirkung auch aufgrund einer verschiedenartigen Auswirkung des externen Magnetfelds auf ein Messsignal und gegebener Unterscheidbarkeit des externen Magnetfelds von einer Bewegung des Gebermagneten erreicht werden.

Vorteilhafterweise kann gemäß Ausführungsformen insbesondere eine Absicherung magnetischer Sensorik-Systeme gegenüber Störeinflüssen durch externe magnetische Umgebungsbedingungen bzw. externe magnetische Felder erreicht werden. Eine Realisierung einer solchen Absicherung ist beispielsweise durch Sicherheitsnormen der Automobilindustrie gefordert, z. B. ISO 26262 etc. Somit kann gemäß Ausführungsformen eine höhere Absicherung gegenüber externen Magnetfeldern sowie ein Schutz für Bevölkerung und Nutzer der Sensorik erreicht werden, da der Common-Cause-Einfluss des externen Magnetfelds erkannt werden kann. Sensoren, Sensorchips bzw. Sensorkanäle, die für eine sensorische Hauptfunktion, wie z. B. Wegmessung, Winkelmessung etc., genutzt werden, können somit auch das Vorhandensein eines Störmagnetfelds erkennen oder erkennbar machen und implizit oder explizit über vorhandene Kanäle kommunizieren, ohne zusätzliche Sensoren und Kanäle speziell hierfür zu benötigen. Auch können sowohl eine Absicherung eines weiten Bereichs externer Magnetfelder bezüglich Stärke und geometrischer Richtung sowie eine zumindest teilweise Kompensation des Einflusses auf ein Nutzsignal durch Rückrechnung des externen Magnetfeldes erreicht werden. Speziell hinsichtlich Anwendungen, die einen weiten Messbereich erfordern oder ermöglichen, ist dieser Vorteil besonders ausgeprägt, da die Anforderungen eines erweiterten Messbereichs und die Anforderungen der Magnetfeldabsicherung mit geringem Aufwand, in Synergie, realisiert werden können. Weitere Vorteile bestehen in einer Erreichung einer höheren ASIL-Klasse (ASIL = Automotive Safety Integrity Level) und in einer Bedienung eines größeren Umfangs benötigter Integritätsstufen mit gleicher Technologie bzw. gleichen Bauteilen, was Skaleneffekte und dadurch Kostenreduktion sowie Streamlining ermöglicht. Verglichen mit einer Abschirmung ganzer Leiterplatten können Bauraum und Kosten eingespart werden. Verglichen mit lediglich einer Abschwächung des externen Magnetfelds kann ein erhöhter Schutz erzielt werden. Dies ist zudem ohne Einsatz kostenintensiver Bauteile, wie beispielsweise mu-Metall, teuren Chips mit spezieller Software, möglich, wodurch eine gute Verfügbarkeit von Bauteilen und Kosteneinsparungen erreicht werden können. Auch können Störeffekte zwischen einer herkömmlichen Abschirmung und einem Nutz-Feld bzw. Gebermagnetfeld eines Gebermagneten vermieden werden, wodurch sich ein erhöhter Schutz, und reduzierte Designeinschränkungen etc. ergeben.

Es wird eine Sensorvorrichtung für ein Fahrzeug gemäß Anspruch 1 vorgestellt.

Die Sensorvorrichtung kann den Gebermagneten aufweisen. Jeder der Magnetfeldsensoren kann zumindest einen Messaufnehmer aufweisen. Die Magnetfeldsensoren können an einer gemeinsamen Leiterplatte oder an mehreren Leiterplatten angeordnet sein. Bei einer Leiterplatte kann es sich um einen Halbleiterchip handeln.

Erfindungsgemäß weist mindestens einer der Magnetfeldsensoren eine Einrichtung zum Abschirmen mindestens einer Komponente des Gebermagnetfelds und zusätzlich oder alternativ des Störmagnetfelds auf.

Die Einrichtung zum Abschirmen kann ausgebildet sein, um mindestens eine Komponente des Gebermagnetfelds und zusätzlich oder alternativ des Störmagnetfelds für den Messaufnehmer zumindest abzuschwächen. Eine solche Ausführungsform bietet den Vorteil, dass der Einfluss des Störmagnetfelds einfach und zuverlässig erkannt bzw. erkennbar gemacht werden kann.

Auch weist erfindungsgemäß mindestens einer der Magnetfeldsensoren eine Einrichtung zum Konzentrieren mindestens einer Komponente des Gebermagnetfelds und zusätzlich oder alternativ des Störmagnetfelds auf.

Die Einrichtung zum Konzentrieren kann ausgebildet sein, um die mindestens eine Komponente des Gebermagnetfelds und zusätzlich oder alternativ des Störmagnetfelds auf den Messaufnehmer zu konzentrieren. Eine solche Ausführungsform bietet den Vorteil, dass magnetische Störeinflüsse zuverlässig und genau identifiziert werden können.

Dabei kann die Einrichtung zum Abschirmen und zusätzlich oder alternativ die Einrichtung zum Konzentrieren ausgebildet sein, um das Gebermagnetfeld und das Störmagnetfeld unterschiedlich zu beeinflussen. Erfindungsgemäß ist die Einrichtung zum Abschirmen beziehungsweise die Einrichtung zum Konzentrieren innerhalb eines Gehäuses der Sensorvorrichtung angeordnet.

Zusätzlich oder alternativ kann die Einrichtung zum Abschirmen und zusätzlich oder alternativ die Einrichtung zum Konzentrieren abhängig von magnetischen Umgebungsbedingungen ausgerichtet sein. Eine solche Ausführungsform bietet den Vorteil, dass der Einfluss des Störmagnetfelds sicher und unaufwändig erkannt bzw. erkennbar gemacht werden kann.

Insbesondere kann mindestens einer der Magnetfeldsensoren die Einrichtung zum Abschirmen und die Einrichtung zum Konzentrieren aufweisen. Hierbei können die Einrichtungen unterschiedlich auf die Magnetfelder wirken. Die Einrichtungen können beispielsweise unterschiedlich stark in verschiedene Raumrichtungen der Magnetfelder wirken. Alternativ kann mindestens ein erster der Magnetfeldsensoren die Einrichtung zum Abschirmen und mindestens ein zweiter der Magnetfeldsensoren die Einrichtung zum Konzentrieren aufweisen. Eine solche Ausführungsform bietet den Vorteil, dass je nach Anforderungen und Gegebenheiten einer Ausführung der Sensorvorrichtung geeignete und zuverlässige Maßnahmen zur Erkennung magnetischer Störfelder ergriffen werden können.

Gemäß einer Ausführungsform kann eine Erfassungsausrichtung mindestens eines Magnetfeldsensors relativ zu einer Erfassungsausrichtung mindestens eines anderen Magnetfeldsensors gedreht sein. Eine Erfassungsausrichtung kann sich auf eine Ausrichtung mindestens einer Erfassungsachse, sensitiven Achse oder empfindlichen Achse des Magnetfeldsensors beziehen. Eine solche Ausführungsform bietet den Vorteil, dass ein unterschiedlicher Einfluss von Magnetfeldern auf die Magnetfeldsensoren erreicht werden kann, wobei Kosten und Bauteile eingespart werden können.

Auch kann mindestens einer der Magnetfeldsensoren eine Einrichtung zum mindestens partiellen Kompensieren des Störmagnetfelds aufweisen. Die Einrichtung kann ausgebildet sein, um einen Kompensationsalgorithmus auszuführen. Eine solche Ausführungsform bietet den Vorteil, dass bereits sensorseitig das Störmagnetfeld herausgerechnet werden kann.

Gemäß einer Ausführungsform kann jeder der Magnetfeldsensoren zur mindestens zweiachsigen Magnetfelderfassung ausgebildet sein. Insbesondere kann hierbei jeder der Magnetfeldsensoren zur Ermittlung und Ausgabe eines magnetischen Winkels ausgebildet sein, der aus mindestens zwei Magnetfeldkomponenten in jeweiliger Achsrichtung ermittelt ist. Eine solche Ausführungsform bietet den Vorteil, dass eine Genauigkeit der Störfeldermittlung erhöht werden kann.

Auch kann das Fahrzeug ein Nutzfahrzeug sein. Zusätzlich oder alternativ können die Magnetfeldsensoren zur Messung einer Position des Gebermagneten bei Anliegen eines Störmagnetfelds der Stärke von bis zu 100 mT, insbesondere von bis zu 50 mT oder bis zu 25 mT bzw. Millitesla ausgelegt sein. Zusätzlich oder alternativ können die Magnetfeldsensoren zur Messung einer Position des Gebermagneten bei Anliegen eines Störmagnetfelds der Stärke von zumindest 1,25 mT, insbesondere von bis zu 3,75 mT bzw. Millitesla ausgelegt sein. Eine solche Ausführungsform bietet den Vorteil, dass auch für Nutzfahrzeuge geltende, erhöhte Umweltbedingungen erfüllt werden können.

Es wird auch ein Verfahren zum Herstellen einer Sensorvorrichtung für ein Fahrzeug gemäß Anspruch 7 vorgestellt.

Durch Ausführen des Verfahrens kann eine Ausführungsform der vorstehend genannten Sensorvorrichtung hergestellt werden.

Es wird ferner ein Verfahren zum Betreiben einer Sensorvorrichtung für ein Fahrzeug vorgestellt, wobei das Verfahren folgende Schritte aufweist:
Einlesen von Sensorsignalen von den zumindest zwei Magnetfeldsensoren eine Ausführungsform der vorstehend genannten Sensorvorrichtung; und
Auswerten der im Schritt des Einlesens eingelesenen Sensorsignale, um Eigenschaften des Gebermagnetfelds zu bestimmen.

Unter Eigenschaften eines Gebermagnetfels kann vorliegend auch eine Position des Gebermagneten verstanden werden.

Das Verfahren kann bzw. die Schritte des Verfahrens können unter Verwendung eines Steuergeräts ausgeführt werden.

Der hier vorgestellte Ansatz schafft ferner ein Steuergerät, das ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form eines Steuergeräts kann die der Erfindung zugrunde liegende Aufgabe schnell und effizient gelöst werden.

Hierzu kann das Steuergerät zumindest eine Recheneinheit zum Verarbeiten von Signalen oder Daten, zumindest eine Speichereinheit zum Speichern von Signalen oder Daten, zumindest eine Schnittstelle zu einem Sensor oder einem Aktor zum Einlesen von Sensorsignalen von dem Sensor oder zum Ausgeben von Steuersignalen an den Aktor und/oder zumindest eine Kommunikationsschnittstelle zum Einlesen oder Ausgeben von Daten aufweisen, die in ein Kommunikationsprotokoll eingebettet sind. Die Recheneinheit kann beispielsweise ein Signalprozessor, ein Mikrocontroller oder dergleichen sein, wobei die Speichereinheit ein Flash-Speicher, ein EEPROM oder eine magnetische Speichereinheit sein kann. Die Kommunikationsschnittstelle kann ausgebildet sein, um Daten drahtlos und/oder leitungsgebunden einzulesen oder auszugeben, wobei eine Kommunikationsschnittstelle, die leitungsgebundene Daten einlesen oder ausgeben kann, diese Daten beispielsweise elektrisch oder optisch aus einer entsprechenden Datenübertragungsleitung einlesen oder in eine entsprechende Datenübertragungsleitung ausgeben kann.

Unter einem Steuergerät kann vorliegend ein elektrisches Gerät verstanden werden, das Sensorsignale verarbeitet und in Abhängigkeit davon Steuer- und/oder Datensignale ausgibt. Das Steuergerät kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen des Steuergeräts beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Es wird auch ein Sensorsystem für ein Fahrzeug vorgestellt, wobei das Sensorsystem folgende Merkmale aufweist:
eine Ausführungsform der vorstehend genannten Sensorvorrichtung; und
eine Ausführungsform des vorstehend genannten Steuergeräts, wobei das Steuergerät signalübertragungsfähig mit der Sensorvorrichtung verbunden ist.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Verschiedene Ausführungsformen können insbesondere eine Anordnung von Magnetfeldsensoren und gegebenenfalls weiteren Elementen mit magnetischen Eigenschaften in einem Sensor-Cluster mit mehr als einem Sensor oder Sensor-Chip, sensorischen Hardware-Element oder sensorischen Kanal betreffen, insbesondere solcher Sensoren oder Sensor-Cluster, die zur Realisierung sicherheitskritischer Anwendungen verwendet werden. Des Weiteren umfassen Ausführungsformen auch technische Umsetzungsmethoden, um die beschriebene Aufgabe zu erreichen.

Ausführungsbeispiele des hier vorgestellten Ansatzes werden in der nachfolgenden Beschreibung mit Bezug zu den Figuren näher erläutert. Es zeigen:
Fig. 1 eine schematische Darstellung eines Fahrzeugs mit einem Sensorsystem gemäß einem Ausführungsbeispiel;
Fig. 2 eine schematische Darstellung einer Sensorvorrichtung gemäß einem Ausführungsbeispiel;
Fig. 3 eine schematische Darstellung eines Sensorsystems gemäß einem Ausführungsbeispiel;
Fig. 4 eine schematische Darstellung einer Sensorvorrichtung gemäß einem Ausführungsbeispiel;
Fig. 5 eine schematische Darstellung einer Sensorvorrichtung gemäß einem Ausführungsbeispiel;
Fig. 6 ein Ablaufdiagramm eines Verfahrens zum Herstellen gemäß einem Ausführungsbeispiel; und
Fig. 7 ein Ablaufdiagramm eines Verfahrens zum Betreiben gemäß einem Ausführungsbeispiel.

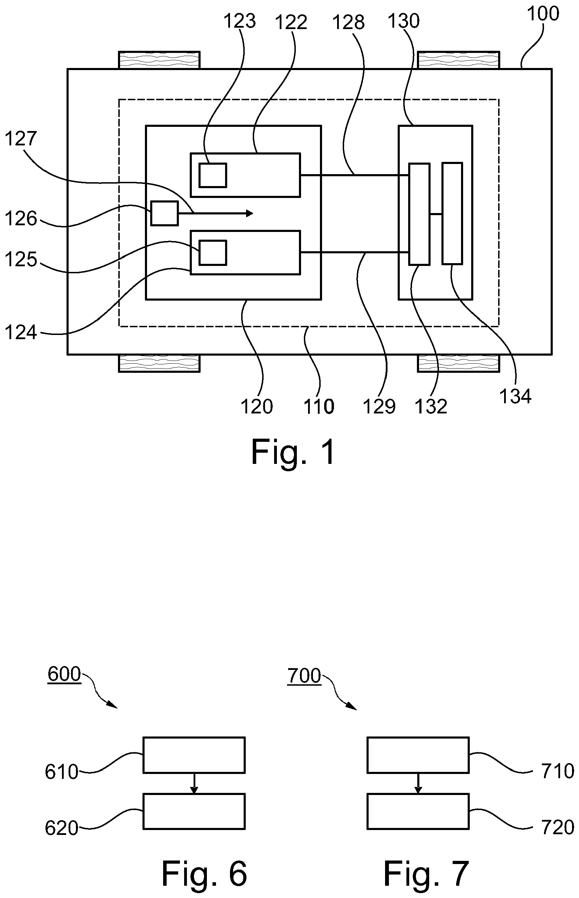

**Fig. 1** zeigt eine schematische Darstellung eines Fahrzeugs 100 mit einem Sensorsystem 110 gemäß einem Ausführungsbeispiel. Das Sensorsystem 110 weist eine Sensorvorrichtung 120 und ein Steuergerät 130 auf.

Die Sensorvorrichtung 120 weist zumindest zwei Magnetfeldsensoren 122 und 124 auf. Ein erster Magnetfeldsensor 122 weist einen ersten Messaufnehmer 123 bzw. Messwertaufnehmer 123 auf. Ein zweiter Magnetfeldsensor 124 weist einen zweiten Messaufnehmer 125 bzw. Messwertaufnehmer 125 auf. Die Sensorvorrichtung 120 weist gemäß dem hier dargestellten Ausführungsbeispiel ferner einen Gebermagneten 126 auf, der ein Gebermagnetfeld 127 erzeugt. Jeder der Magnetfeldsensoren 122 und 124 ist ausgebildet, um das Gebermagnetfeld 127 des Gebermagneten 126 zu erfassen.

Die Magnetfeldsensoren 122 und 124 sind so ausgebildet, dass das Gebermagnetfeld 127 und ein externes Störmagnetfeld von einer Störquelle unterschiedlich auf die Messaufnehmer 123 und 125 der Magnetfeldsensoren 122 und 124 wirken. Der erste Magnetfeldsensor 122 ist ausgebildet, um ein erstes Sensorsignal 128 bereitzustellen. Der zweite Magnetfeldsensor 124 ist ausgebildet, um ein zweites Sensorsignal 129 bereitzustellen.

Das Steuergerät 130 ist signalübertragungsfähig mit der Sensorvorrichtung 120 verbunden. Das Steuergerät 130 ist ausgebildet, um die Sensorvorrichtung 120 zu betreiben. Dazu weist das Steuergerät 130 eine Einleseeinrichtung 132 und eine Auswerteeinrichtung 134 auf. Die Einleseeinrichtung 132 ist ausgebildet, um die Sensorsignale 128 und 129 von den Magnetfeldsensoren 122 und 124 der Sensorvorrichtung 120 einzulesen. Die Auswerteeinrichtung 134 ist ausgebildet, um die mittels der Einleseeinrichtung 132 eingelesenen Sensorsignale 128 und 129 auszuwerten, um das Gebermagnetfeld 127 zu bestimmen. Hierbei ist das Steuergerät 130 ausgebildet, um das unter Bezugnahme auf Fig. 7 beschriebene Verfahren auszuführen.

Gemäß einem Ausführungsbeispiel ist das Fahrzeug 100 ein Nutzfahrzeug, beispielsweise ein Lastkraftwagen oder dergleichen. Hierbei sind die Magnetfeldsensoren 122 und 124 für Magnetfeldstärken des Störmagnetfelds ausgelegt, wobei die Messung des Gebermagnetfelds für die Erfassung der Gebermagnetposition verwendet werden kann.

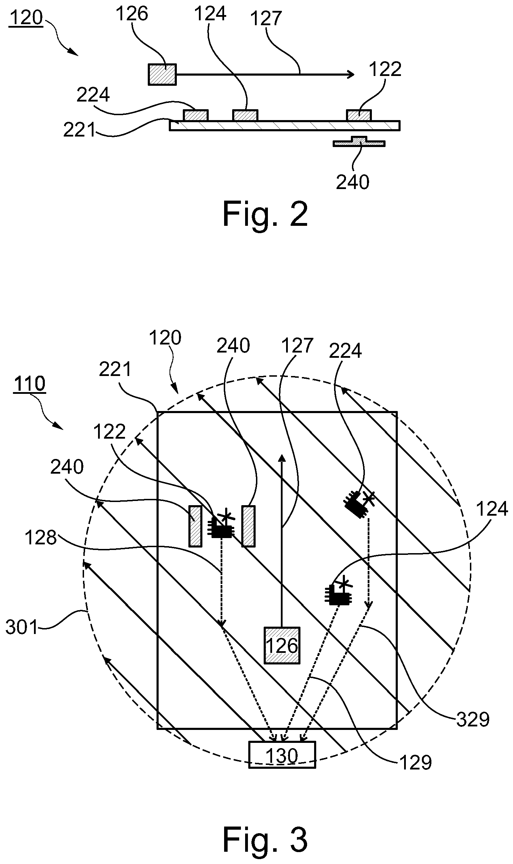

**Fig. 2** zeigt eine schematische Darstellung einer Sensorvorrichtung 120 gemäß einem Ausführungsbeispiel. Die Sensorvorrichtung 120 entspricht oder ähnelt der Sensorvorrichtung aus Fig. 1. Hierbei ist die Sensorvorrichtung 120 in einer Seitenansicht dargestellt. Die Sensorvorrichtung 120 gemäß dem hier dargestellten Ausführungsbeispiel weist einen ersten Magnetfeldsensor 122, einen zweiten Magnetfeldsensor 124 und einen dritten Magnetfeldsensor 224 auf, die an einer Leiterplatte 221 bzw. einem Chip oder Sensor-Chip 221 angeordnet sind. Hierbei sind die Magnetfeldsensoren 122, 124 und 224 an einer ersten von zwei Hauptoberflächen der Leiterplatte 221 angeordnet. Die Sensorvorrichtung 120 weist ferner einen Gebermagneten 126 auf, der ein Gebermagnetfeld 127 erzeugt. Der Gebermagnet 126 ist benachbart zu den Magnetfeldsensoren 122, 124 und 224 angeordnet. Ferner weist der erste Magnetfeldsensor 122 eine Einrichtung 240 zum Abschirmen und/oder zum Konzentrieren mindestens einer Komponente des Gebermagnetfelds 127 und/oder eines externen Störmagnetfelds auf. Die Einrichtung 240 zum Abschirmen und/oder zum Konzentrieren ist an einer zweiten der zwei Hauptoberflächen der Leiterplatte 221 angeordnet. Somit ist die Leiterplatte 221 zwischen den Magnetfeldsensoren 122, 124 und 224, insbesondere dem ersten Magnetfeldsensor 122, und der Einrichtung 240 zum Abschirmen und/oder zum Konzentrieren angeordnet.

Die Einrichtung 240 zum Abschirmen und/oder zum Konzentrieren ist gemäß einem Ausführungsbeispiel ausgebildet, um das Gebermagnetfeld 127 und das externe Störmagnetfeld unterschiedlich zu beeinflussen. Auch ist die Einrichtung 240 zum Abschirmen und/oder zum Konzentrieren gemäß einem Ausführungsbeispiel abhängig von magnetischen Umgebungsbedingungen in einer Umgebung der Sensorvorrichtung 120 ausgerichtet und/oder positioniert. Auch wenn es in Fig. 2 nicht explizit dargestellt ist, kann die Sensorvorrichtung 120 auch ein Gehäuse aufweisen. Hierbei kann die Einrichtung 240 zum Abschirmen und/oder zum Konzentrieren innerhalb oder außerhalb des Gehäuses angeordnet sein. Gemäß einem Ausführungsbeispiel kann auch der zweite Magnetfeldsensor 124 und/oder der dritte Magnetfeldsensor 224 eine weitere Einrichtung 240 zum Abschirmen und/oder zum Konzentrieren aufweisen.

Gemäß einem Ausführungsbeispiel weist einer oder mindestens einer der Magnetfeldsensoren 122, 124 und 224, beispielsweise der erste Magnetfeldsensor 122, eine Einrichtung 240 zum Abschirmen und zum Konzentrieren auf. Alternativ kann einer oder mindestens einer der Magnetfeldsensoren 122, 124 und 224, beispielsweise der erste Magnetfeldsensor 122, eine Einrichtung zum Abschirmen und eine Einrichtung zum Konzentrieren aufweisen, wobei die Einrichtungen unterschiedlich auf die Magnetfelder wirken. Alternativ kann mindestens ein erster der Magnetfeldsensoren 122, 124 und 224 eine Einrichtung zum Abschirmen und mindestens ein zweiter der Magnetfeldsensoren 122, 124 und 224 eine Einrichtung zum Konzentrieren aufweisen.

Anders ausgedrückt bestehen zum Erreichen des Zustands, dass die Magnetfeldsensoren 122, 124 und 224 so ausgebildet sind, dass das Gebermagnetfeld 127 und ein externes Störmagnetfeld von einer Störquelle unterschiedlich auf die Messaufnehmer der Magnetfeldsensoren 122, 124 und 224 wirken, unter anderem nachfolgend genannte Möglichkeiten.
- Einsatz einer Schirmung oder Abschirmung als magnetischer Manipulator bzw. Einrichtung 140, die gezielt am Ort mindestens eines Magnetfeldsensors 122, 124 bzw. 224 eine Schwächung mindestens einer Komponente des externen Störmagnetfelds erzeugt. Hierbei ist die Art der Schwächung verschiedenartig, insbesondere in Richtung und/oder Gesamtfeldstärke, im Bezug darauf, ob es sich um ein externes Störmagnetfeld oder das Gebermagnetfeld 127 des Gebermagneten 126 handelt, welches sich etwa durch Bewegung des Gebermagneten 126 verändert. Die Schirmung kann innerhalb oder außerhalb eines Sensor(-Cluster)-Gehäuses angebracht sein. Außerdem kann eine solche Einrichtung 140 durch gezielte Anbringung, beispielsweise bezüglich Winkel, Ort etc., des Magnetfeldsensors 122, 124 bzw. 224 in Bezug auf die magnetische Umgebung, z. B. metallische Teile in der Umgebung der Sensorvorrichtung 120, realisiert sein.
- Einsatz eines magnetischen Konzentrators als Manipulator bzw. Einrichtung 140, die gezielt am Ort mindestens eines Magnetfeldsensors 122, 124 bzw. 224 eine Konzentration mindestens einer Komponente des Gebermagnetfelds 127 und/oder des externen Störmagnetfelds erzeugt. Hierbei ist die Art der Konzentration verschiedenartig, insbesondere in Richtung und/oder Gesamtfeldstärke, im Bezug darauf, ob es sich um ein externes Störmagnetfeld oder das Gebermagnetfeld 127 des Gebermagneten 126 handelt, welches sich etwa durch Bewegung des Gebermagneten 126 verändert. Der Konzentrator kann innerhalb oder außerhalb eines Sensor(-Cluster)-Gehäuses angebracht sein. Außerdem kann eine solche Einrichtung 140 durch gezielte Anbringung, beispielsweise bezüglich Winkel, Ort etc., des Magnetfeldsensors 122, 124 bzw. 224 in Bezug auf die magnetische Umgebung, z. B. metallische Teile in der Umgebung der Sensorvorrichtung 120, realisiert sein.
   - Kombinationen aus Schirmung und Konzentrator, wobei die Wirkung auf das Gebermagnetfeld 127 gegenüber der Wirkung auf das externe Störmagnetfeld am selben Ort unterschiedlich ist. Dabei kann das Gebermagnetfeld 127 gestärkt werden und das externe Störmagnetfeld geschwächt werden oder umgekehrt. Auch kann bei beiden Magnetfeldern eine Schwächung oder Erhöhung vorliegen, die unterschiedlich stark ausgeprägt ist. Dies kann durch eine geometrische Anordnung der Schirmung und des Konzentrators erreicht werden. Dies funktioniert dann, wenn das Gebermagnetfeld und das Störmagnetfeld nicht exakt den gleichen Richtungsvektor haben.
   - Kombinationen aus Schirmung und Konzentrator, wobei die Kombination in Bezug auf verschiedene Magnetfeldsensoren 122, 124 bzw. 224 (d. h., an verschiedenen Orten) auf die Signalwerte verschieden wirkt. Beispielsweise kann der Magnetfeldsensor 122, 124 bzw. 224 ein auf eine erste Art verändertes Magnetfeld erfahren, während die anderen Magnetfeldsensoren ein auf eine zweite Art verändertes oder unverändertes Magnetfeld erfahren.

**Fig. 3** zeigt eine schematische Darstellung eines Sensorsystems 110 gemäß einem Ausführungsbeispiel. Das Sensorsystem 110 entspricht oder ähnelt dem Sensorsystem aus Fig. 1. Dabei ist das Sensorsystem 110 in einer Draufsicht dargestellt. Gezeigt sind von dem Sensorsystem 110 hierbei die Sensorvorrichtung 120, welche der Sensorvorrichtung aus einer der vorstehend beschriebenen Figuren entspricht oder ähnelt, und das Steuergerät 130, das eine Logik, zum Beispiel einen Komparator etc., aufweist. Ferner ist in der Darstellung von Fig. 3 ein externes Störmagnetfeld 301 von einer Störquelle bzw. die Projektion dieses Magnetfelds in die 2D-Zeichnungsebene oder der in der Zeichnungsebene liegende Anteil eines externen Magnetfelds schematisch dargestellt.

Die Sensorvorrichtung 120 gemäß dem hier dargestellten Ausführungsbeispiel weist einen ersten Magnetfeldsensor 122, einen zweiten Magnetfeldsensor 124 und einen dritten Magnetfeldsensor 224 auf, die an einer Leiterplatte 221 bzw. einem Chip oder Sensor-Chip 221 angeordnet sind. Die Sensorvorrichtung 120 weist ferner einen Gebermagneten 126 auf, der ein Gebermagnetfeld 127 erzeugt. Der Gebermagnet 126 ist benachbart zu den Magnetfeldsensoren 122, 124 und 224 angeordnet. Ferner weist der erste Magnetfeldsensor 122 eine Einrichtung 240 zum Abschirmen und/oder zum Konzentrieren mindestens einer Komponente des Gebermagnetfelds 127 und/oder des externen Störmagnetfelds 301 auf. Somit entspricht die Sensorvorrichtung 120 der Sensorvorrichtung aus Fig. 2 mit Ausnahme dessen, dass in der Darstellung von Fig. 3 erkennbar ist, dass der dritte Magnetfeldsensor 224 bezüglich der anderen Magnetfeldsensoren 122 und 124 gedreht angeordnet ist. Hierbei ist eine Erfassungsausrichtung des dritten Magnetfeldsensors 224 relativ zu Erfassungsausrichtungen des ersten Magnetfeldsensors 122 und des zweiten Magnetfeldsensors 124 gedreht.

Anders ausgedrückt wird der Zustand, dass die Magnetfeldsensoren 122, 124 und 224 so ausgebildet sind, dass das Gebermagnetfeld 127 und das externe Störmagnetfeld 301 unterschiedlich auf die Messaufnehmer der Magnetfeldsensoren 122, 124 und 224 wirken, auch durch eine Drehung der Orientierung mindestens eines Magnetfeldsensors, hier des dritten Magnetfeldsensors 224, relativ zu den anderen Magnetfeldsensoren, hier den Magnetfeldsensoren 122 und 124, erreicht. Hierbei sind sensitive Achsen der Magnetfeldsensoren 122, 124 und 224 derart orientiert, dass der Einfluss verschiedenartig ist, je nachdem, ob es sich um das externe Störmagnetfeld 301 oder das Gebermagnetfeld 127 des Gebermagneten 126 handelt, welches sich etwa durch Bewegung des Gebermagneten 126 verändert.

In der Darstellung von Fig. 3 sind auch das erste Sensorsignal 128 und das zweite Sensorsignal 129 wie in Fig. 1 sowie ferner ein drittes Sensorsignal 329 symbolisch eingezeichnet, wobei das dritte Sensorsignal 329 zwischen dem dritten Magnetfeldsensoren 224 und dem Steuergerät 130 übertragen wird.

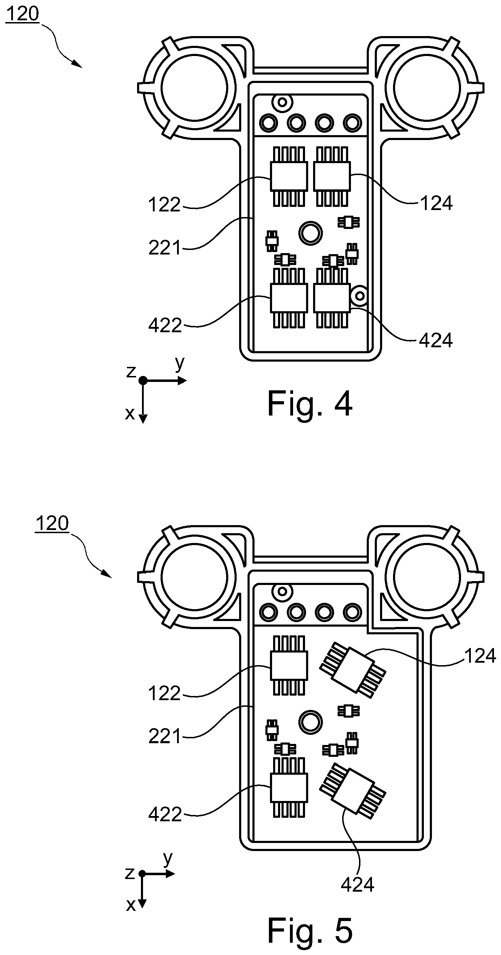

**Fig. 4** zeigt eine schematische Darstellung einer Sensorvorrichtung 120 gemäß einem Ausführungsbeispiel. In dem in der Fig. 4 dargestellten Beispiel ist der hier vorgestellte Ansatz nicht unmittelbar sichtbar realisiert, verglichen mit der gedrehten Umsetzung der Sensorkaskade 2, wie sie in der nachfolgenden Figur näher dargestellt ist. Die Sensorvorrichtung 120 entspricht oder ähnelt hierbei der Sensorvorrichtung aus einer der vorstehend beschriebenen Figuren. Von der Sensorvorrichtung 120 sind in der Darstellung von Fig. 4 hierbei die Leiterplatte 221, der erste Magnetfeldsensor 122, der zweiten Magnetfeldsensor 124, ein weiterer erster Magnetfeldsensor 422 und ein weiterer zweiter Magnetfeldsensor 424 gezeigt. Genauer gesagt entspricht die Sensorvorrichtung 120 in Fig. 4 der Sensorvorrichtung aus Fig. 1 mit Ausnahme dessen, dass der weitere erste Magnetfeldsensor 422 und der weitere zweite Magnetfeldsensor 424 vorgesehen sind. Der weitere erste Magnetfeldsensor 422 und der weitere zweite Magnetfeldsensor 424 dienen einer Erweiterung des Messbereichs der Sensorvorrichtung 120. Ferner ist in Fig. 4 ein dreiachsiges XYZ-Bezugskoordinatensystem eingezeichnet. Gemäß dem hier dargestellten Ausführungsbeispiel sind die Erfassungsausrichtungen der Magnetfeldsensoren 122, 124, 422 und 424 in einer XY-Ebene des XYZ-Bezugskoordinatensystems gleich bzw. identisch. In der Darstellung aus der Fig. 4 ist eine Verschaltung der Komponenten 124 und 412 gewählt worden, die zur Erweiterung des Messbereichs dient bzw. andersherum verwendet werden kann.

**Fig. 5** zeigt eine schematische Darstellung einer Sensorvorrichtung 120 gemäß einem Ausführungsbeispiel. Die Sensorvorrichtung 120 in Fig. 5 entspricht hierbei der Sensorvorrichtung aus Fig. 4 mit Ausnahme dessen, dass der zweite Magnetfeldsensor 124 und der weitere zweite Magnetfeldsensor 424 relativ zu dem ersten Magnetfeldsensor 122 und dem weiteren ersten Magnetfeldsensor 422 in der XY-Ebene des XYZ-Bezugskoordinatensystems gedreht sind. Genauer gesagt sind die Erfassungsausrichtungen des zweiten Magnetfeldsensors 124 und des weiteren zweiten Magnetfeldsensors 424 relativ zu dem ersten Magnetfeldsensor 122 und dem weiteren ersten Magnetfeldsensor 422 in der XY-Ebene des XYZ-Bezugskoordinatensystems gedreht.

Unter Bezugnahme auf die vorstehend beschriebenen Figuren sei angemerkt, dass gemäß einem Ausführungsbeispiel mindestens einer der Magnetfeldsensoren 122, 124 bzw. 122, 124, 224 bzw. 122, 124, 422, 424 eine Einrichtung zum mindestens partiellen Kompensieren des Störmagnetfelds 301 aufweisen kann. Anders ausgedrückt kann mindestens einer der Magnetfeldsensoren 122, 124 bzw. 122, 124, 224 bzw. 122, 124, 422, 424 Mechanismen, beispielsweise Algorithmen, etc., zur Kompensation oder Teil-Kompensation externer Magnetfelder 301 aufweisen. Auch wenn die Kompensationswirkung des mindestens einen solchen der Magnetfeldsensoren 122, 124 bzw. 122, 124, 224 bzw. 122, 124, 422, 424 nur teilweise bzw. nur in beschränkten Magentfeldstärkenbereichen wirkt, so ergibt sich doch ein zur Erkennung nutzbarer Einfluss auf Ebene der Sensorvorrichtung 120 bzw. des Sensorsystems 110.

Ferner sei unter Bezugnahme auf die vorstehend beschriebenen Figuren auch angemerkt, dass jeder der Magnetfeldsensoren 122, 124 bzw. 122, 124, 224 bzw. 122, 124, 422, 424 zur mindestens zweiachsigen Magnetfelderfassung ausgebildet sein kann. Hierbei kann jeder der Magnetfeldsensoren 122, 124 bzw. 122, 124, 224 bzw. 122, 124, 422, 424zur Ermittlung und Ausgabe eines magnetischen Winkels ausgebildet sein, der aus mindestens zwei Magnetfeldkomponenten in jeweiliger Achsrichtung ermittelt ist.

Es kann auch ein weiterer Aspekt für eine engere Auslegung berücksichtigt werden. Beispielsweise beschreiben zwei Eigenschaften die Verschiedenartigkeit des Einflusses auf die Kanäle. Es kann in einem Ausführungsbeispiel eine Auslegung dergestalt vorgesehen sein, dass es im Bereich der (weiter verbreiteten Anforderungen) bezüglich homogener Störmagnetmagnetfeldern geringer bis mäßiger Stärke 0 bis 1000 bzw. 0 bis 3000 A/m d zu keiner (bzw. nur zu einer geringen Abweichung / unter der Grenze des Komparators) kommt. Somit kommt es nicht (bzw. nur in einem vergleichsweise kleinen Bereich von Raumwinkeln) zu einer Erkennung dieser Felder. Es kann in einem Ausführungsbeispiel eine Auslegung dergestalt vorgesehen sein, dass diese geringen bis mäßigen Felder nur einen tolerierbar geringen Wertefehler im Signal nach sich ziehen.

Beides kann als wichtiger Aspekt für Stabilität des Systems betrachtet werden, um tolerant gegenüber Feldern zu sein, deren Wirkung ausreichend klein ist, um nicht die Anforderungen an den maximal erlaubbaren Fehler im Signalwert zu gefährden. Dies bedingt eine teilweise Gleichläufigkeit der Einflüsse, bzw. Beschränkung der Gegenläufigkeit.

Weiterhin kann eine Auslegung dergestalt sein, dass der Signalfehler (mindestens in Teilen des Raumwinkelbereichs des externen Störmagnetfelds und der Positionen des Gebermagnets, ideal wäre unter jedem Winkel und jeder Position) reduziert wird. Es wächst also der gleichläufige Anteil des Fehlers langsamer als die Messwerte (mm) der beiden Sensoren/Kanäle auseinanderstreben. Dies bedingt einen Mindesteinfluss der Maßnahmen (d. h. der Wirkung der Schirmung oder des Konzentrators) oder Methoden bzw. einen Mindestwinkel zwischen den Sensoren etc..

**Fig. 6** zeigt ein Ablaufdiagramm eines Verfahrens 600 zum Herstellen gemäß einem Ausführungsbeispiel. Das Verfahren 600 zum Herstellen ist ausführbar, um eine Sensorvorrichtung für ein Fahrzeug herzustellen. Hierbei ist das Verfahren 600 zum Herstellen ausführbar, um die Sensorvorrichtung aus einer der vorstehend beschriebenen Figuren oder eine ähnliche Sensorvorrichtung herzustellen.

Das Verfahren 600 zum Herstellen weist einen Schritt 610 des Bereitstellens und einen Schritt 620 des Anordnens und/oder Ausbildens auf. Im Schritt 610 des Bereitstellens werden zumindest zwei Magnetfeldsensoren zum Erfassen eines Gebermagnetfelds von einem Gebermagneten bereitgestellt. Im Schritt 620 des Anordnens und/oder Ausbildens werden die Magnetfeldsensoren so angeordnet und/oder ausgebildet, dass das resultierende Magnetfeld aus dem Gebermagnetfeld und einem externen Störmagnetfeld von einer Störquelle in unterschiedlichen Magnetfeldsensoren eine unterschiedliche Stärke der Wirkung entfaltet.

**Fig. 7** zeigt ein Ablaufdiagramm eines Verfahrens 700 zum Betreiben gemäß einem Ausführungsbeispiel. Das Verfahren 700 zum Betreiben ist ausführbar, um eine Sensorvorrichtung für ein Fahrzeug zu betreiben. Dabei ist das Verfahren 700 zum Betreiben in Verbindung mit der Sensorvorrichtung aus einer der vorstehend beschriebenen Figuren oder einer ähnlichen Sensorvorrichtung ausführbar. Auch ist das Verfahren 700 zum Betreiben unter Verwendung des Steuergeräts aus einer der vorstehend beschriebenen Figuren oder eines ähnlichen Steuergeräts ausführbar.

Das Verfahren 700 zum Betreiben weist einen Schritt 710 des Einlesens und einen Schritt 720 des Auswertens auf. Im Schritt 710 des Einlesens werden Sensorsignale von den zumindest zwei Magnetfeldsensoren der Sensorvorrichtung eingelesen. Im Schritt 720 des Auswertens werden die im Schritt 710 des Einlesens eingelesenen Sensorsignale ausgewertet, um Eigenschaften des Gebermagnetfelds zu bestimmen.

### BEZUGSZEICHENLISTE

- 100: Fahrzeug
- 110: Sensorsystem
- 120: Sensorvorrichtung
- 122: erster Magnetfeldsensor
- 123: erster Messaufnehmer bzw. Messwertaufnehmer
- 124: zweiter Magnetfeldsensor
- 125: zweiter Messaufnehmer bzw. Messwertaufnehmer
- 126: Gebermagnet
- 127: Gebermagnetfeld
- 128: erstes Sensorsignal
- 129: zweites Sensorsignal
- 130: Steuergerät
- 132: Einleseeinrichtung
- 134: Auswerteeinrichtung
- 221: Leiterplatte bzw. (Sensor-)Chip
- 224: dritter Magnetfeldsensor
- 240: Einrichtung zum Abschirmen und/oder zum Konzentrieren
- 301: externes Störmagnetfeld
- 329: drittes Sensorsignal
- 422: weiterer erster Magnetfeldsensor
- 424: weiterer zweiter Magnetfeldsensor
- 600: Verfahren zum Herstellen
- 610: Schritt des Bereitstellens
- 620: Schritt des Anordnens und/oder Ausbildens
- 700: Verfahren zum Betreiben
- 710: Schritt des Einlesens
- 720: Schritt des Auswertens

## Patentansprüche

1. Sensorvorrichtung (120) für ein Fahrzeug (100), wobei die Sensorvorrichtung (120) zumindest zwei Magnetfeldsensoren (122, 124; 224; 422, 424) zum Erfassen eines Gebermagnetfelds (127) von einem Gebermagneten (126) aufweist, wobei die Magnetfeldsensoren (122, 124; 224; 422, 424) so ausgebildet sind, dass das resultierende Magnetfeld aus dem Gebermagnetfeld (127) und einem externen Störmagnetfeld (301) von einer Störquelle auf die Magnetfeldsensoren (122, 124; 224; 422, 424) eine unterschiedliche Stärke der Wirkung bezüglich Signalwerten der betreffenden Magnetfeldsensoren (122, 124; 224; 422, 424) entfaltet, **dadurch gekennzeichnet, dass** mindestens einer der Magnetfeldsensoren (122, 124; 224; 422, 424) eine Einrichtung (240) zum Abschirmen mindestens einer Komponente des Gebermagnetfelds (127) und/oder des Störmagnetfelds (301) aufweist und mindestens einer der Magnetfeldsensoren (122, 124; 224; 422, 424) eine Einrichtung (240) zum Konzentrieren mindestens einer Komponente des Gebermagnetfelds (127) und/oder des Störmagnetfelds (301) aufweist, wobei die Einrichtung oder die Einrichtungen (240) innerhalb eines Gehäuses der Sensorvorrichtung (120) angeordnet ist bzw. sind.

2. Sensorvorrichtung (120) gemäß Anspruch 1, **dadurch gekennzeichnet, dass** die Einrichtung (240) ausgebildet ist, um das Gebermagnetfeld (127) und das Störmagnetfeld (301) unterschiedlich zu beeinflussen.

3. Sensorvorrichtung (120) gemäß einem der vorangegangenen Ansprüche, **dadurch gekennzeichnet, dass** mindestens einer der Magnetfeldsensoren (122, 124; 224; 422, 424) die Einrichtung (240) zum Abschirmen und die Einrichtung (240) zum Konzentrieren aufweist, wobei die Einrichtungen (240) unterschiedlich auf die Magnetfelder (127, 301) wirken, oder dass mindestens ein erster der Magnetfeldsensoren (122, 124; 224; 422, 424) die Einrichtung (240) zum Abschirmen und mindestens ein zweiter der Magnetfeldsensoren (122, 124; 224; 422, 424) die Einrichtung (240) zum Konzentrieren aufweist.

4. Sensorvorrichtung (120) gemäß einem der vorangegangenen Ansprüche, **dadurch gekennzeichnet, dass** eine Erfassungsausrichtung mindestens eines Magnetfeldsensors (124; 224; 424) relativ zu mindestens einer Erfassungsausrichtung mindestens eines anderen Magnetfeldsensors (122; 422) gedreht ist und/oder dass mindestens einer der Magnetfeldsensoren (122, 124; 224; 422, 424) eine Einrichtung zum mindestens partiellen Kompensieren des Störmagnetfelds (301) aufweist.

5. Sensorvorrichtung (120) gemäß einem der vorangegangenen Ansprüche, **dadurch gekennzeichnet, dass** jeder der Magnetfeldsensoren (122, 124; 224; 422, 424) zur mindestens zweiachsigen Magnetfelderfassung ausgebildet ist, insbesondere wobei jeder der Magnetfeldsensoren (122, 124; 224; 422, 424) zur Ermittlung und Ausgabe eines magnetischen Winkels ausgebildet ist, der aus mindestens zwei Magnetfeldkomponenten in jeweiliger Achsrichtung (X, Y, Z) ermittelt ist.

6. Sensorvorrichtung (120) gemäß einem der vorangegangenen Ansprüche, **dadurch gekennzeichnet, dass** das Fahrzeug (100) ein Nutzfahrzeug ist und/oder die Magnetfeldsensoren (122, 124; 224; 422, 424) zur Messung einer Position eines des Gebermagneten (126) bei Anliegen eines des Störmagnetfelds (301) von bis zu 100 Millitesla, insbesondere von bis zu 50 Millitesla oder bis zu 25 Millitesla ausgelegt sind.

7. Verfahren (600) zum Herstellen einer Sensorvorrichtung (120) für ein Fahrzeug (100), wobei das Verfahren (600) folgende Schritte aufweist:
Bereitstellen (610) von zumindest zwei Magnetfeldsensoren (122, 124; 224; 422, 424) zum Erfassen eines Gebermagnetfelds (127) von einem Gebermagneten (126); und
Anordnen (620) und/oder Ausbilden (620) der Magnetfeldsensoren (122, 124; 224; 422, 424), so dass das resultierende Magnetfeld aus dem Gebermagnetfeld (127) und einem externen Störmagnetfeld (301) von einer Störquelle auf die Magnetfeldsensoren (122, 124; 224; 422, 424) eine unterschiedliche Stärke der Wirkung bezüglich Signalwerten der betreffenden Magnetfeldsensoren (122, 124; 224; 422, 424) entfaltet, so dass mindestens einer der Magnetfeldsensoren (122, 124; 224; 422, 424) eine Einrichtung (240) zum Abschirmen mindestens einer Komponente des Gebermagnetfelds (127) und/oder des Störmagnetfelds (301) aufweist und so dass mindestens einer der Magnetfeldsensoren (122, 124; 224; 422, 424) eine Einrichtung (240) zum Konzentrieren mindestens einer Komponente des Gebermagnetfelds (127) und/oder des Störmagnetfelds (301) aufweist, wobei die Einrichtung oder die Einrichtungen (240) innerhalb eines Gehäuses der Sensorvorrichtung (120) angeordnet wird bzw. werden.

8. Verfahren (700) zum Betreiben einer Sensorvorrichtung (120) für ein Fahrzeug (100), wobei das Verfahren (700) folgende Schritte aufweist:
Einlesen (710) von Sensorsignalen (128, 129; 329) von den zumindest zwei Magnetfeldsensoren (122, 124; 224; 422, 424) der Sensorvorrichtung (120) gemäß einem der Ansprüche 1 bis 6; und
Auswerten (720) der im Schritt (710) des Einlesens eingelesenen Sensorsignale (128, 129; 329), um Eigenschaften des Gebermagnetfelds (127) zu bestimmen.

9. Steuergerät (130), das eingerichtet ist, um die Schritte des Verfahrens (700) gemäß Anspruch 8 in entsprechenden Einheiten (132, 134) auszuführen.

10. Sensorsystem (110) für ein Fahrzeug (100), wobei das Sensorsystem (110) folgende Merkmale aufweist:
eine Sensorvorrichtung (120) gemäß einem der Ansprüche 1 bis 6; und
ein Steuergerät (130) gemäß Anspruch 9, wobei das Steuergerät (130) signalübertragungsfähig mit der Sensorvorrichtung (120) verbunden ist.

11. Computerprogramm, umfassend Befehle, die bei der Ausführung des Programms durch einen Computer diesen veranlassen, ein Verfahren (700) gemäß Anspruch 8 auszuführen.

12. Maschinenlesbares Speichermedium, auf dem das Computerprogramm nach Anspruch 11 gespeichert ist.

## Claims

1. Sensor device (120) for a vehicle (100), wherein the sensor device (120) comprises at least two magnetic field sensors (122, 124; 224; 422, 424) for detecting a sensing magnetic field (127) from a sensing magnet (126), wherein the magnetic field sensors (122, 124; 224; 422, 424) are designed in such a way that the resultant magnetic field from the sensing magnetic field (127) and an external magnetic interference field (301) from an interference source has on the magnetic field sensors (122, 124; 224; 422, 424) a different strength of effect with respect to signal values of the relevant magnetic field sensors (122, 124; 224; 422, 424),
**characterized in that**
at least one of the magnetic field sensors (122, 124; 224; 422, 424) comprises a device (240) for shielding at least one component of the sensing magnetic field (127) and/or the magnetic interference field (301) and at least one of the magnetic field sensors (122, 124; 224; 422, 424) comprises a device (240) for concentrating at least one component of the sensing magnetic field (127) and/or the magnetic interference field (301), wherein the device or the devices (240) is or are arranged inside a housing of the sensor device (120).

2. Sensor device (120) according to Claim 1, **characterized in that** the device (240) is designed to influence the sensing magnetic field (127) and the magnetic interference field (301) in different ways.

3. Sensor device (120) according to either of the preceding claims, **characterized in that** at least one of the magnetic field sensors (122, 124; 224; 422, 424) comprises the shielding device (240) and the concentrating device (240), wherein the devices (240) act on the magnetic fields (127, 301) in different ways, or that at least a first of the magnetic field sensors (122, 124; 224; 422, 424) comprises the shielding device (240) and at least a second of the magnetic field sensors (122, 124; 224; 422, 424) comprises the concentrating device (240).

4. Sensor device (120) according to any one of the preceding claims, **characterized in that** a detection orientation of at least one magnetic field sensor (124; 224; 424) is rotated relative to at least one detection orientation of at least one other magnetic field sensor (122; 422) and/or that at least one of the magnetic field sensors (122, 124; 224; 422, 424) comprises a device for at least partially compensating for the magnetic interference field (301).

5. Sensor device (120) according to any one of the preceding claims, **characterized in that** each of the magnetic field sensors (122, 124; 224; 422, 424) is designed for at least two-axis magnetic field sensing, in particular wherein each of the magnetic field sensors (122, 124; 224; 422, 424) is designed to determine and output a magnetic angle determined from at least two magnetic field components in the respective axial direction (X, Y, Z).

6. Sensor device (120) according to any one of the preceding claims, **characterized in that** the vehicle (100) is a utility vehicle and/or the magnetic field sensors (122, 124; 224; 422, 424) are designed for measuring a position of one of the sensing magnets (126) when a magnetic interference field (301) of up to 100 millitesla, in particular of up to 50 millitesla or up to 25 millitesla, is present.

7. Method (600) for producing a sensor device (120) for a vehicle (100), wherein the method (600) comprises the following steps:
providing (610) at least two magnetic field sensors (122, 124; 224; 422, 424) for detecting a sensing magnetic field (127) from a sensing magnet (126); and
arranging (620) and/or implementing (620) the magnetic field sensors (122, 124; 224; 422, 424) in such a way that the resultant magnetic field from the sensing magnetic field (127) and an external magnetic interference field (301) from an interference source has on the magnetic field sensors (122, 124; 224; 422, 424) a different strength of effect with respect to signal values of the relevant magnetic field sensors (122, 124; 224; 422, 424), such that at least one of the magnetic field sensors (122, 124; 224; 422, 424) comprises a device (240) for shielding at least one component of the sensing magnetic field (127) and/or the magnetic interference field (301) and such that at least one of the magnetic field sensors (122, 124; 224; 422, 424) comprises a device (240) for concentrating at least one component of the sensing magnetic field (127) and/or the magnetic interference field (301), wherein the device or the devices (240) is or are arranged inside a housing of the sensor device (120).

8. Method (700) for operating a sensor device (120) for a vehicle (100), wherein the method (700) comprises the following steps:
reading in (710) sensor signals (128, 129; 329) from the at least two magnetic field sensors (122, 124; 224; 422, 424) of the sensor device (120) according to any one of Claims 1 to 6; and
evaluating (720) the sensor signals (128, 129; 329) read in during the reading-in step (710) to determine properties of the sensing magnetic field (127).

9. Control unit (130), which is configured to execute the steps of the method (700) according to Claim 8 in corresponding units (132, 134).

10. Sensor system (110) for a vehicle (100), wherein the sensor system (110) comprises the following features:
a sensor device (120) according to any one of Claims 1 to 6; and
a control unit (130) according to Claim 9, wherein the control unit (130) is connected to the sensor device (120) such that it is capable of signal transmission.

11. Computer program comprising commands which, when the program is executed by a computer, cause said computer to execute a method (700) according to Claim 8.

12. Machine-readable storage medium, on which the computer program according to Claim 11 is stored.

## Revendications

1. Dispositif (120) capteur pour un véhicule (100), dans lequel le dispositif (120) capteur a au moins deux capteurs (122, 124 ; 224 ; 422, 424) de champ magnétique pour la détection d'un champ (127) magnétique donneur d'un aimant (126) donneur, dans lequel les capteurs (122, 124 ; 224 ; 422, 424) de champ magnétique sont constitués de manière à ce que le champ magnétique résultant, composé du champ (127) magnétique donneur et d'un champ (301) magnétique parasite extérieur, déploie sur les capteurs (122, 124 ; 224 ; 422, 424) de champ magnétique une intensité différente de l'effet, en ce qui concerne des valeurs de signal, des capteurs (122, 124 ; 224 ; 422, 424) de champ magnétique concernés,
**caractérisé en ce qu'**
au moins l'un des capteurs (122, 124 ; 224 ; 422, 424) de champ magnétique a un dispositif (240) de protection vis-à-vis d'au moins une composante du champ (127) magnétique donneur et/ou du champ (301) magnétique parasite et au moins l'un des capteurs (122, 124 ; 224 ; 422, 424) de champ magnétique a un dispositif (240) de concentration d'au moins une composante du champ (127) magnétique donneur et/ou du champ (301) magnétique parasite, dans lequel le dispositif ou les dispositifs (240) est ou sont disposés à l'intérieur d'un boîtier du dispositif (120) capteur.

2. Dispositif (120) capteur suivant la revendication 1, **caractérisé en ce que** le dispositif (240) est constitué pour influencer différemment le champ (127) magnétique et le champ (301) magnétique parasite.

3. Dispositif (120) capteur suivant l'une des revendications précédentes, **caractérisé en ce qu'**au moins l'un des capteurs (122, 124 ; 224 ; 422, 424) de champ magnétique a le dispositif (240) de protection et le dispositif (240) de concentration, dans lequel les dispositifs (240) agissent différemment sur les champs (127, 301) magnétiques, ou **en ce qu'**au moins un premier des capteurs (122, 124 ; 224 ; 422, 424) de champ magnétique a le dispositif (240) de protection et au moins un deuxième des capteurs (122, 124 ; 224 ; 422, 424) de champ magnétique a le dispositif (240) de concentration.

4. Dispositif (120) capteur suivant l'une des revendications précédentes, **caractérisé en ce qu'**au moins une direction de détection d'au moins un capteur (124 ; 224 ; 424) de champ magnétique est tournée par rapport au moins une direction de détection d'au moins un autre capteur (122 ; 422) de champ magnétique et/ou **en ce qu'**au moins l'un des capteurs (122, 124 ; 224 ; 422, 424) de champ magnétique a un dispositif de compensation au moins partielle du champ (301) magnétique parasite.

5. Dispositif (120) capteur suivant l'une des revendications précédentes, **caractérisé en ce que** chacun des capteurs (122, 124 ; 224 ; 422, 424) de champ magnétique est constitué pour la détection de champs magnétiques suivant au moins deux axes, dans lequel, en particulier chacun des capteurs (122, 124 ; 224 ; 422, 424) de champ magnétique est constitué pour la détection et la sortie d'au moins un angle magnétique, qui est déterminé à partir d'au moins deux composantes de champ magnétique dans la direction (X, Y, Z) d'axe respective.

6. Dispositif (120) capteur suivant l'une des revendications précédentes, **caractérisé en ce que** le véhicule (100) est un véhicule utilitaire et/ou les capteurs (122, 124 ; 224 ; 422, 424) de champ magnétique sont conçus pour la mesure d'une position de l'un des aimants (126) donneurs, lors de l'application de l'un des champs (301) magnétiques parasites de jusqu'à 100 millitesla, en particulier de jusqu'à 50 millitesla ou de jusqu'à 25 millitesla.

7. Procédé (600) de fabrication d'un dispositif (120) capteur pour un véhicule (100), dans lequel le procédé (600) a les stades suivants :
on se procure (610) au moins deux capteurs (122, 124 ; 224 ; 422, 424) de champ magnétique pour la détection d'un champ (127) magnétique donneur d'un aimant (126) donneur ; et
on met (620) et/ou on constitue (620) des capteurs (122, 124 ; 224 ; 422, 424) de champ magnétique, de manière à ce que le champ magnétique résultant, composé du champ (127) magnétique donneur et d'un champ (301) magnétique parasite extérieur, déploie sur les capteurs (122, 124 ; 224 ; 422, 424) de champ magnétique une intensité différente de l'effet, en ce qui concerne des valeurs de signal, des capteurs (122, 124 ; 224 ; 422, 424) de champ magnétique concernés, de sorte qu'au moins l'un des capteurs (122, 124 ; 224 ; 422, 424) de champ magnétique a un dispositif (240) de protection vis-à-vis d'au moins une composante du champ (127) magnétique donneur et/ou du champ (301) magnétique parasite et de sorte qu'au moins l'un des capteurs (122, 124 ; 224 ; 422, 424) de champ magnétique a un dispositif (240) de concentration d'au moins une composante du champ (127) magnétique donneur et/ou du champ (301) magnétique parasite, dans lequel on dispose le dispositif ou les dispositifs (240) dans un boîtier du dispositif (120) capteur.

8. Procédé (700) pour faire fonctionner un dispositif (120) capteur pour un véhicule (100), dans lequel le procédé (700) a les stades suivants :
lecture (710) de signaux (128, 129 ; 329) de capteur des au moins deux capteurs (122, 124 ; 224 ; 422, 424) de champ magnétique du dispositif (120) capteur suivant l'une des revendications 1 à 6 ; et
analyse (720) des signaux (128, 129 ; 329) de capteur lus dans le stade (710) de la lecture pour déterminer des propriétés du champ (127) magnétique donneur.

9. Appareil (130) de commande, qui est agencé pour effectuer les stades du procédé (700) suivant la revendication 8 dans des unités (132, 134) correspondantes.

10. Système (110) capteur pour un véhicule (100), dans lequel le système (110) capteur a les caractéristiques suivantes :
un dispositif (120) capteur suivant l'une des revendications 1 à 6 ; et
un appareil (130) de commande suivant la revendication 9, dans lequel l'appareil (130) de commande est relié de manière à pouvoir transmettre un signal au dispositif (120) capteur.

11. Programme d'ordinateur comprenant des instructions, qui, lors de la réalisation du programme par un ordinateur, font que celles-ci effectuent un procédé (700) suivant la revendication 8.

12. Support de mémoire, déchiffrable par machine, sur lequel le programme d'ordinateur de la revendication 11 est mis en mémoire.
